# EUROPEAN PATENT APPLICATION

(11) **EP 2 312 619 A1**
(43) Date of publication of application: **20.04.2011**
(21) Application number: 09804838.2
(22) Date of filing: 07.07.2009
(51) Int. Cl.: H01L 21/3205, H01L 21/302, H01L 21/768, H01L 23/52

(54) **METHOD FOR MANUFACTURING SEMICONDUCTOR DEVICE**

(30) Priority: 07.08.2008 JP 2008204214
(71) Applicant: Fujikura, Ltd., Tokyo 135-8512 (JP)
(72) Inventor: NUKAGA Osamu, Sakura-shi Chiba 285-8550 (JP); YAMAMOTO Satoshi, Sakura-shi Chiba 285-8550 (JP)
(74) Representative: Cabinet Plasseraud
(86) International application number: PCT/JP2009/062384
(87) International publication number: WO 2010/016351

(57) **Abstract**

A method for manufacturing a semiconductor device according to the present invention includes: an electrode formation step of forming an electrode on one surface of a semiconductor substrate; a through hole formation step of forming a through hole in the thickness direction of the semiconductor substrate starting from a position on the other surface of the semiconductor substrate corresponding to the position of the electrode formed on the one surface of the substrate; a first insulating layer formation step of forming a first insulating layer on at least an inner circumferential surface, a periphery of an opening, and a bottom surface of the through hole; a modifying step of reforming a first portion of the first insulating layer formed on the bottom surface of the through hole to form a ; a modified region removal step of removing the modified region to expose the electrode inside the through hole; and a conductive layer formation step of forming a conductive layer on the electrode exposed inside the through hole and on the first insulating layer such that the conductive layer is electrically connected with the electrode. FIG. 3A.

## Description

### TECHNICAL FIELD

The present invention relates to a method for producing a semiconductor device equipped with a through electrode. More specifically, the present invention relates to a method for producing a semiconductor device, in which the etching selectivity for the insulating layer inside a through hole is improved, the degree of design freedom for the shape of a through electrode is enhanced, and the processing throughput is improved.
Priority is claimed on Japanese Patent Application No. 2008-204214, filed August 7, 2008, the content of which is incorporated herein by reference.

### BACKGROUND ART

Instead of wire bonding which has been used in the packages of optical elements such as an image sensor, a wafer level package using a through electrode for the connection with an element has been proposed recently.

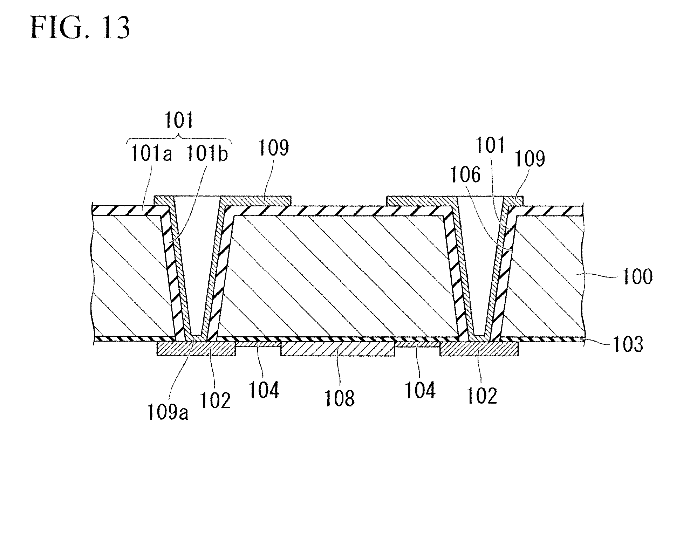

An example of a conventional semiconductor device is shown in FIG. 13. This semiconductor device is mainly constituted of a semiconductor substrate 100 having an insulating layer 103 formed on one surface thereof; a functional element 108 and an electrode pad 102 each arranged on the surface; and an interconnection section 104 which electrically connects the functional element 108 and the electrode pad 102. In addition, a through hole 106 is formed so as to penetrate the semiconductor substrate 100 in the thickness direction thereof, so that the electrode pad 102 is exposed from the other surface side of the semiconductor substrate 100. Further, this semiconductor device includes insulating layers 101 (101a and 101b) arranged in the other surface of the semiconductor substrate 100 and the inner peripheral surface of the through hole 106; and rewiring layers 109 arranged on top of the insulating layer 101b inside the through hole 106 and on top of the electrode pad 102 exposed inside the through hole 106.
The interconnection section 104 and the functional element 108, the interconnection section 104 and the electrode pad 102, and the electrode pad 102 and a portion 109a of the rewiring layer 109, are electrically connected with each other. According to such a connection structure, conduction of the functional element 108 with the other surface side of the semiconductor substrate 100 becomes possible via the interconnection section 104, the electrode pad 102 and the rewiring layer 109.

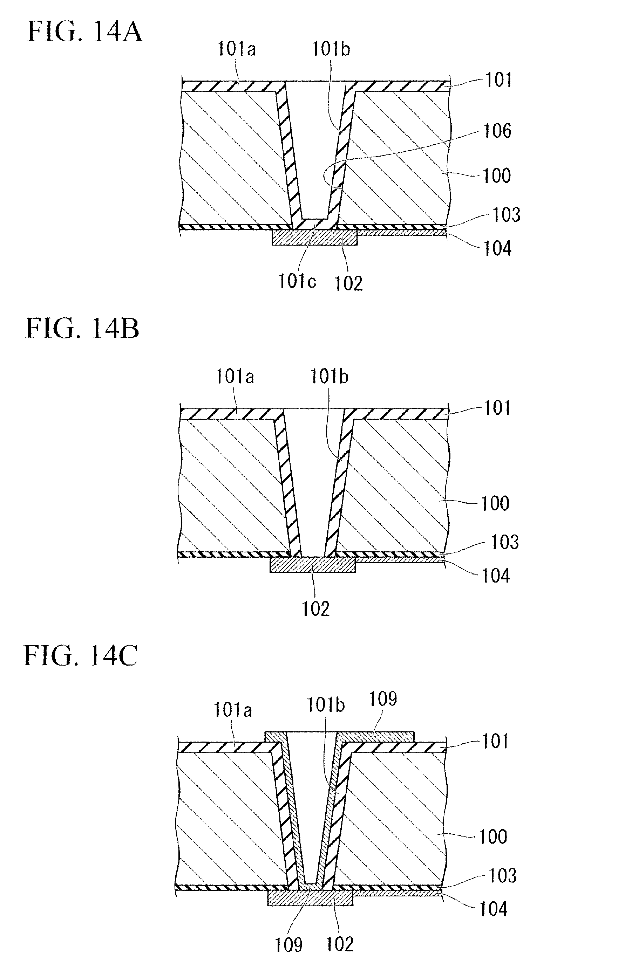

A conventional method for forming a through electrode in the semiconductor substrate 100 will be explained with reference to FIGS. 14A to 14C.
First, as shown in FIG. 14A, the through hole 106 is formed in the semiconductor substrate 100 made of a Si substrate or the like. During this process, the through hole 106 is formed so that a portion of the electrode pad (I/O pad) 102 provided in the surface side where devices of the semiconductor substrate 100 are formed is exposed inside the through hole 106. Subsequently, in order to provide insulation with the semiconductor substrate 100, the insulating layers 101 made of a silicon oxide film are formed on the surface of the semiconductor substrate 100 and the inner peripheral surface of the through hole 106 by a chemical vapor deposition (CVD) process or the like.
During this process, as shown in FIG. 14A, the insulating layer 101c is also formed on top of the electrode pad 102 (hereafter, sometimes referred to as a bottom face of the through hole 106) which is exposed inside the through hole 106. Accordingly, in the next step, this insulating layer 101c is removed by an etching method, such as a reactive ion etching (RIE) process, which is highly anisotropic (refer to FIG. 14B). Finally, as shown in FIG. 14C, the rewiring layer 109 is formed so as to be electrically connected with the electrode pad 102. Note that this conventional method is disclosed, for example, in Patent Document 1.

However, in the above-mentioned conventional method, when carrying out an etching of the insulating layer 101c arranged on the bottom face of the through hole 106, the insulating layer 101a arranged on the surface of the semiconductor substrate 100 and the insulating layer 101b arranged on the inner peripheral surface of the through hole 106 will also be etched in the same manner. That is, since the insulating layers 101a and 101b formed on the inner peripheral surface of the through hole 106 and/or the surface of the semiconductor substrate 100 are also being removed when removing the insulating layer 101c on the bottom face of the through hole 106, it has been difficult to maintain the insulation properties inside the through hole 106 and in the periphery of the opening thereof. In order to maintain the insulation properties, it is necessary to form the insulating layers 101a and 101b with extremely larger film thicknesses than that of the insulating layer 101c, followed by the removal of the insulating layer 101c on the bottom face of the through hole 106 while also etching the insulating layers 101a and 101b to a certain degree. As described above, since the thickness of the insulating layers 101 is determined depending on the insulating-layer formation process and the etching process, it is difficult to set conditions in terms of the thickness of the respective insulating layers 101a, 101b and 101c. In addition, in this case, since the time for forming and etching the insulating layers increases, there is a concern that the throughput during the processing may degrade.

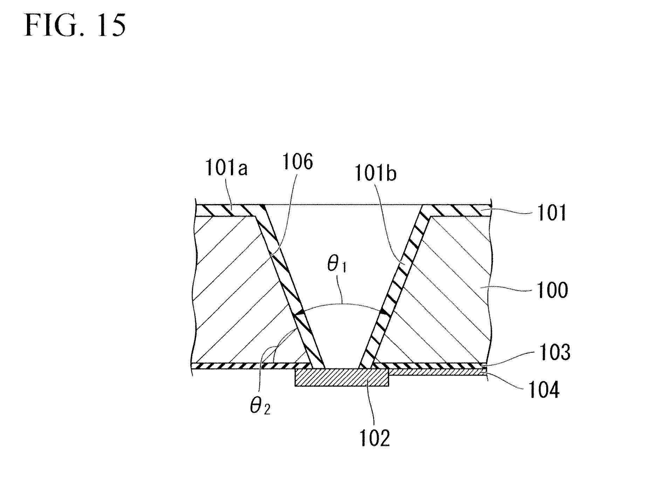

Further, in general, when forming a conductor inside the through hole using a sputtering method, a plating method or the like, for example, as shown in FIG. 15, the processing becomes easier as an opening angle θ₁ of the inner peripheral surface of the through hole 106 when seen in the cross section including the axis thereof increases (in other words, as an angle θ₂ reduces, which is formed between the surface of the semiconductor substrate 100 where the insulating layer 103 is formed and the inner peripheral surface of the through hole 106 when seen in the same cross section). However, since the insulating layer 101b formed on the inner peripheral surface of the through hole 106 becomes prone to be etched as the opening angle θ₁ increases, it is difficult to form the shape shown in FIG. 15 using the above-mentioned conventional method.
Further, it is also possible to etch inside the through hole by opening the resist on the through hole using a photolithography technique (not shown). However, in this case, there is a concern that the resin component of the resist may remain inside the through hole when removing the resist. Moreover, it is also possible that the surface of the semiconductor substrate may be etched due to the problem of positional accuracy of the opening. For this reason, it is difficult to employ a photolithography technique.

### PRIOR ART DOCUMENTS

### PATENT DOCUMENTS

[Patent Document 1] Japanese Unexamined Patent Application, First Publication No. 2007-294821

### DISCLOSURE OF INVENTION

### PROBLEMS TO BE SOLVED BY THE INVENTION

The present invention takes the above circumstances into consideration, with an object of providing a method for producing a semiconductor device capable of forming a through electrode which is easily obtained and also with an enhanced degree of design freedom with respect to the shape thereof.

### MEANS FOR SOLVING THE PROBLEMS

The present invention employs the following in order to solve the above-mentioned problems and to achieve the object. In particular, (1) A method for manufacturing a semiconductor device according to the present invention includes: an electrode formation step of forming an electrode on one surface of a semiconductor substrate; a through hole formation step of farming a through hole in the thickness direction of the semiconductor substrate starting from a position on the other surface of the semiconductor substrate corresponding to the position of the electrode formed on the one surface of the substrate; a first insulating layer formation step of farming a first insulating layer on at least an inner circumferential surface, a periphery of an opening, and a bottom surface of the through hole; a modifying step of reforming a first portion of the first insulating layer formed on the bottom surface of the through hole to form a modified region; a modified region removal step of removing the modified region to expose the electrode inside the through hole; and a conductive layer formation step of forming a conductive layer on the electrode exposed inside the through hole and on the first insulating layer such that the conductive layer is electrically connected with the electrode.

(2) In the method for manufacturing a semiconductor device according to the above-mentioned aspect (1), it may be arranged such that: the method further includes a second insulating layer formation step of forming a second insulating layer on the one surface prior to the electrode formation step, wherein the second insulating layer is removed at the same time as the formation of the through hole in the through hole formation step.
(3) In the method for manufacturing a semiconductor device according to the above-mentioned aspect (1), it may be arranged such that: the method further includes a second insulating layer formation step of forming a second insulating layer on the one surface prior to the electrode formation step, wherein a second portion of the second insulating layer which corresponds to the first portion is collectively reformed together with the first portion, thereby forming the modified region in the modifying step.
(4) In the method for manufacturing a semiconductor device according to the above-mentioned aspect (1), it may be arranged such that: the modifying step is carried out by focusing and irradiating a laser beam having a pulse duration of not more than 10 picoseconds on the first portion.
(5) In the method for manufacturing a semiconductor device according to the above-mentioned aspect (4), it may be arranged such that: the laser beam has a pulse energy lower than the energy, at which the ablation or transpiration of the first insulating layer occurs.

### EFFECTS OF THE INVENTION

In the method for manufacturing a semiconductor device according to the above-mentioned aspect (1), a modifying step of reforming a first portion of the first insulating layer formed on the bottom surface of the through hole to form a modified region; and a modified region removal step of removing the modified region to expose the electrode inside the through hole; are included. For this reason, among the first insulating layer, only the first portion which is covering the electrode can be selectively removed while leaving the insulated portion which is formed on the inner peripheral surface of the through hole and in the periphery of the opening thereof. In this manner, for example, setting of conditions in terms of the thickness of the first insulating layer in the periphery of the through hole becomes easy. As a result, in the present invention, a through electrode which is easily obtained and also with an enhanced degree of design freedom with respect to the shape thereof can be formed.

### BRIEF DESCRIPTION OF THE DRAWINGS

FIG. 1 is a diagram schematically showing a semiconductor device manufactured by a method for manufacturing a semiconductor device according to a first embodiment of the present invention, which is a cross sectional view when seen in the cross section along the plate thickness direction thereof.
FIG. 2A is a cross sectional diagram schematically showing a step in the method for manufacturing a semiconductor device.
FIG. 2B is a cross sectional diagram schematically showing a subsequent step in the method for manufacturing a semiconductor device.
FIG. 2C is a cross sectional diagram schematically showing a subsequent step in the method for manufacturing a semiconductor device.
FIG. 3A is a cross sectional diagram schematically showing a subsequent step in the method for manufacturing a semiconductor device.
FIG. 3B is a cross sectional diagram schematically showing a subsequent step in the method for manufacturing a semiconductor device.
FIG. 3C is a cross sectional diagram schematically showing a subsequent step in the method for manufacturing a semiconductor device.
FIG. 4 is a cross sectional diagram schematically showing an example in which the present invention is applied to a through hole having an inner wall surface which is perpendicular to the surface of the semiconductor substrate.
FIG. 5 is a cross sectional diagram schematically showing the state where a laser beam is irradiated using a cylindrical lens or the like.
FIG. 6 is a cross sectional diagram schematically showing the state where a laser beam which does not transmit through silicon is irradiated.
FIG. 7 is a cross sectional diagram schematically showing the state of a laser assisted etching process.
FIG. 8A is a diagram schematically showing a step in a method for manufacturing a semiconductor device according to a second embodiment of the present invention, which is a cross sectional view when seen in the cross section along the plate thickness direction of the semiconductor device.
FIG. 8B is a cross sectional diagram schematically showing a subsequent step in the method for manufacturing a semiconductor device.
FIG. 8C is a cross sectional diagram schematically showing a subsequent step in the method for manufacturing a semiconductor device.
FIG. 9A is a cross sectional diagram schematically showing a subsequent step in the method for manufacturing a semiconductor device.
FIG. 9B is a cross sectional diagram schematically showing a subsequent step in the method for manufacturing a semiconductor device.
FIG. 9C is a cross sectional diagram schematically showing a subsequent step in the method for manufacturing a semiconductor device.
FIG. 10A is a diagram schematically showing a semiconductor device manufactured by a method for manufacturing a semiconductor device according to a third embodiment of the present invention, which is a cross sectional view when seen in the cross section along the plate thickness direction thereof.
FIG. 10B is a diagram showing a portion of the semiconductor device, which is an enlarged view of a section A in FIG. 10A.
FIG 11A is a cross sectional diagram schematically showing a step in the method for manufacturing a semiconductor device.
FIG. 11B is a cross sectional diagram schematically showing a subsequent step in the method for manufacturing a semiconductor device.
FIG 11C is a cross sectional diagram schematically showing a subsequent step in the method for manufacturing a semiconductor device.
FIG. 12A is a cross sectional diagram schematically showing a subsequent step in the method for manufacturing a semiconductor device.
FIG. 12B is a cross sectional diagram schematically showing a subsequent step in the method for manufacturing a semiconductor device.
FIG. 12C is a cross sectional diagram schematically showing a subsequent step in the method for manufacturing a semiconductor device.
FIG. 13 is a diagram showing an example of a conventional semiconductor device, which is a cross sectional view when seen in the cross section along the plate thickness direction thereof.
FIG. 14A is a cross sectional diagram schematically showing a step for removing an insulating layer that covers the bottom face of a through hole in a conventional method for manufacturing a semiconductor device.
FIG. 14B is a cross sectional diagram schematically showing a step for removing an insulating layer that covers the bottom face of a through hole which follows the above step.
FIG. 14C is a cross sectional diagram schematically showing a step for forming a rewiring layer which follows the above step.
FIG. 15 is a diagram schematically showing a semiconductor substrate having a through hole with a large opening angle of the inner peripheral surface, which is a cross sectional view when seen in the cross section along the plate thickness direction thereof.

### EMBODIMENTS FOR CARRYING OUT THE INVENTION

Each embodiment of a method for manufacturing a semiconductor device according to the present invention will be described below with reference to the drawings.

### [First Embodiment]

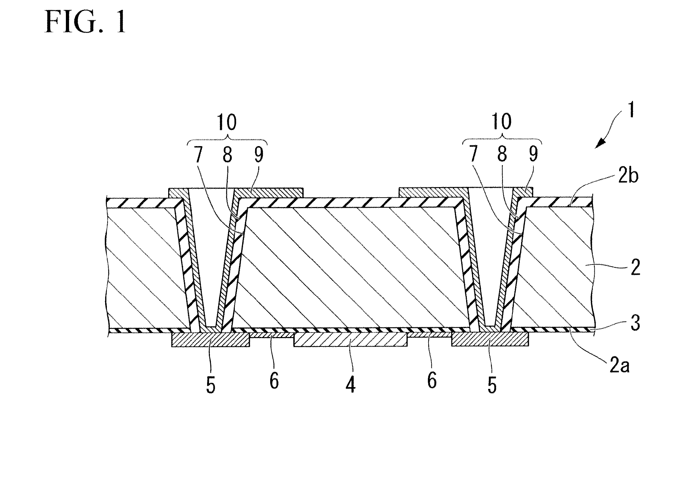

FIG. 1 is a diagram showing a semiconductor device 1 manufactured by a method for manufacturing a semiconductor device according to a first embodiment of the present invention, which is a cross sectional view when seen in the cross section along the plate thickness direction thereof.
This semiconductor device 1 is mainly constituted of: a semiconductor substrate 2 in which an insulating layer 3 is formed on the surface in the lower side of FIG. 1; a functional element 4 and a plurality of electrode pads 5 arranged on one surface 2a of the semiconductor substrate 2 via the insulating layer 3; and a plurality of interconnection sections 6 which electrically connect the functional element 4 and each of the electrode pads 5.
In this semiconductor substrate 2, a plurality of through holes 7 are formed which become wider from the one surface 2a towards the other surface 2b of the semiconductor substrate 2, and each of the electrode pads 5 is exposed inside these through holes 7. In addition, this semiconductor device 1 further includes: an insulating layer 8 which is formed at least on the inner peripheral surface of the through hole 7 and in the periphery of the opening thereof; and a plurality of conductive layers 9 which are formed on top of the insulating layer 8 and on top of each of the electrode pads 5 exposed inside the through hole 7. Each of the conductive layers 9 is electrically connected to each of the electrode pads 5. A through electrode 10 is formed due to the conductive layers 9 which are formed inside and outside the through hole 7 via the insulating layer 8.

Next, a method for manufacturing the semiconductor device 1 having the above-mentioned constitution will be described below with reference to the drawings.

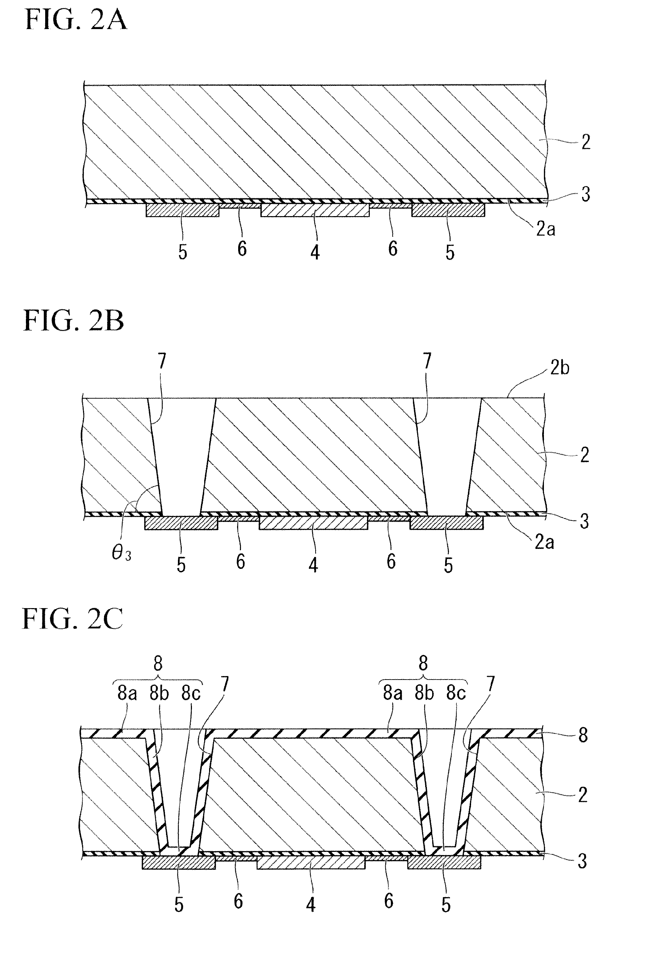

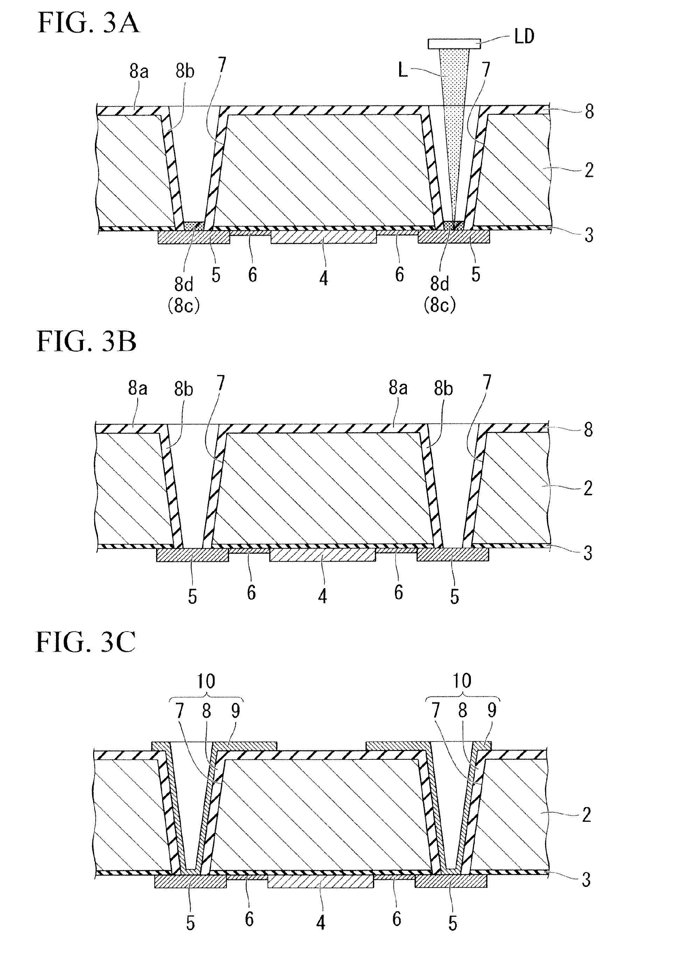

FIGS. 2A to 2C and FIGS. 3A to 3C are cross sectional diagrams schematically showing the method for manufacturing a semiconductor device of the present embodiment in the process sequence.
The method for manufacturing a semiconductor device of the present embodiment includes, in the following order: an electrode formation step in which a plurality of electrode pads 5 are formed on one surface 2a of the semiconductor substrate 2; a through hole formation step of forming a plurality of through holes 7 so that at least a portion of each of the electrode pads 5 is exposed from the other surface 2b of the semiconductor substrate 2; an insulating layer formation step of forming the insulating layer 8 on at least the inner circumferential surface and the periphery of the opening of each of the through holes 7, and on top of each of the electrode pads 5 exposed inside each of the through holes 7; a modifying step of reforming each portion of the insulating layer 8 (a portion of an insulating layer 8c) which covers over each of the electrode pads 5 exposed inside each of the through holes 7, respectively, to form modified regions 8d; a modified region removal step of removing these modified regions 8d; and a conductive layer formation step of forming the conductive layers 9 on the electrode pads 5 exposed inside the through holes 7 and on the insulating layer 8 in such a manner that the conductive layers 9 are electrically connected with the electrode pads 5.

In the present embodiment, a portion of the insulating layer 8 (a portion of the insulating layer 8c) which covers the electrodes (the bottom faces of the through holes 7) exposed inside each of the through holes 7 is reformed, and is then removed. For this reason, only the insulating layer 8c which is a portion covering each of the electrode pads 5 exposed inside each of the through holes 7 can be selectively removed while leaving the insulating layer 8 which is formed on the inner peripheral surface of each of the through holes 7. In this manner, for example, setting of conditions in terms of the thickness of the insulating layer 8 in the periphery of each of the through electrodes 10 becomes easy. As a result, in the present embodiment, the through electrode 10 which is easily obtained and also with an enhanced degree of design freedom with respect to the shape thereof can be formed.

Each steps in the method for manufacturing a semiconductor device according to the present embodiment will be described below in order.

### (Electrode formation step)

First, the electrode pad 5 is formed on one surface 2a of the semiconductor substrate 2. That is, as shown in FIG. 2A, the semiconductor substrate 2 in which the functional element 4 is formed via the insulating layer 3 is prepared, and a plurality of electrode pads 5 (I/O pads) and a plurality of interconnection sections 6 are formed on top of the insulating layer 3 which constitutes the one surface 2a (a lower surface present in the lower side of the same drawing).
Note that the insulating layer 3 is formed in the step for forming the insulating layer 3 on the one surface 2a (i.e., the second insulating layer formation step) in advance prior to the electrode formation step.

The semiconductor substrate 2 may be a semiconductor wafer such as a silicon wafer or a semiconductor chip prepared by cutting (dicing) the semiconductor wafer into a chip size. When the semiconductor substrate 2 is a semiconductor chip, a plurality of semiconductor chips can be prepared by first forming a plurality of pairs of various semiconductor elements, ICs, functional elements 4 or the like on top of the semiconductor wafer, followed by cutting into a chip size.

The functional element 4 in the present embodiment is configured from, for example, a transistor, a photodiode or the like.

As the material for the electrode pad 5, for example, a material having excellent conductivity such as aluminum (Al), copper (Cu), an aluminum-silicon (Al-Si) alloy, an aluminum-silicon-copper (Al-Si-Cu) alloy or the like can be suitably used.

The interconnection section 6 forms a circuit by electrically connecting the electrode pad 5 and the functional element 4 and the like.
As the material for the interconnection section 6, the same material for the electrode pad 5 may be used, and a material having excellent conductivity such as aluminum (Al), copper (Cu), an aluminum-silicon (Al-Si) alloy, an aluminum-silicon-copper (Al-Si-Cu) alloy or the like is suitable. In addition, the interconnection section 6 can also be formed by doping an impurity such as boron (B) into the semiconductor substrate 2.

### (Through hole formation step)

Subsequently, as shown in FIG. 2B, a plurality of through holes 7 are formed so that at least a portion of the electrode pads 5 is exposed from the other surface 2b of the semiconductor substrate 2.
These through holes 7 are formed so that the electrode pads 5 are exposed from the upper surface side of the semiconductor substrate 2. The diameter or cross sectional shape of each of the through holes 7 is not particularly limited and is appropriately set in accordance with the thickness of the semiconductor substrate 2 or the desired purpose, and their positions can also be determined appropriately depending on the interconnection formed on the semiconductor substrate 2. Although the shape of each of the through holes 7 in the longitudinal cross section is ideal where an angle θ₃ formed between the one surface 2a of the semiconductor substrate 2 and the inner peripheral surface of each of the through holes 7, when viewing these through holes 7 in the cross sections that include these axes, is 90° (perpendicular), the angle may be about 80° to about 100°.

For the formation of the through holes 7, for example, a deep-reactive ion etching (DRIE) process, a wet etching process, a machining process using a micro-drill or the like, an optical excitation electrolytic polishing process or the like can be used.

### (Insulating layer formation step (first insulating layer formation step))

Subsequently, the insulating layer 8 is formed at least on the inner peripheral surface and the periphery of the opening of each of the through holes 7, and on each of the electrode pads 5 exposed inside each of the through holes 7. That is, as shown in FIG. 2C, the insulating layer 8 is formed at least on the inner wall surface (i.e., the inner peripheral surface and the bottom face) and the periphery of the opening of the through holes 7. The insulating layer 8 can be formed, for example, by depositing silicon oxide (SiO₂ by a plasma CVD method or the like.

Although the material for the insulating layer 8 is not limited to the materials which can be deposited by CVD, it is preferable to employ a material which causes a structural change by the irradiation of a laser beam having a pulse width of not more than 10 picoseconds and also which can be removed by dry etching, wet etching or laser assisted etching, so that the reforming and removal steps as described later can be carried out. In addition to the above-mentioned SiO₂, examples of such materials include borosilicate glass.

### (Modifying step)

Subsequently, a portion of the insulating layer 8 which covers each of the electrode pads 5 exposed inside each of the through holes 7 is reformed, thereby forming a modified region. That is, as shown in FIG. 3A, a laser beam L having a pulse duration on the order of not more than 10 picoseconds is irradiated from a laser device LD and focused only at the insulating layer 8c which covers the bottom faces of the through holes 7 (i.e., the electrode pads 5), thereby reforming the insulating layer 8c. As the laser beam L used for reforming, a laser beam having a wavelength range which transmits silicon (semiconductor substrate 2) is used. By scanning the bottom face of the through hole 7 with the beam using a light focusing portion, an insulating layer (i.e., the modified region 8d) with a changed structure is formed at the bottom face. As a result, a structural change (reforming) can be easily caused at a portion of the insulating layer 8c where the laser beam L has been irradiated.
The term "reforming" in the present description refers to a phenomenon in which a portion irradiated with laser undergoes a structural change, and the level of resistance against etching gas degrades as compared to the portion which has not been irradiated with laser.

As the laser beam L used for reforming, it is preferable to use a laser beam having a pulse energy lower than the energy, at which the ablation or transpiration of the insulating layer 8 occurs.
It is also possible to cause the ablation and removal of the insulating layer 8c by irradiating a laser beam having a pulse duration on the order of not more than 10 picoseconds, a laser beam having a longer pulse duration than the above laser beam, a CW laser beam or the like onto the insulating layer 8c. However, in such cases, damage to the electrode pads 5 will be greater. As a result, problems arise, such as the deformation, breakage, partial loss or the like of the electrode pads 5, and the attachment of residues inside the through holes 7. By using a laser beam having a pulse energy lower than the energy, at which the ablation or transpiration of the insulating layer 8 occurs, as the laser beam L, the insulating layer 8c can be reformed by causing only a structural change to the insulating layer 8c without damaging the electrode pads 5.
As described above, by irradiating a pulse laser beam L having a pulse duration on the order of not more than 10 picoseconds while suppressing the energy to a level equal to or less than the energy, at which the ablation or transpiration of the insulating layer 8 occurs, the processing without causing damage or the like to the electrode pads 5 can be carried out.

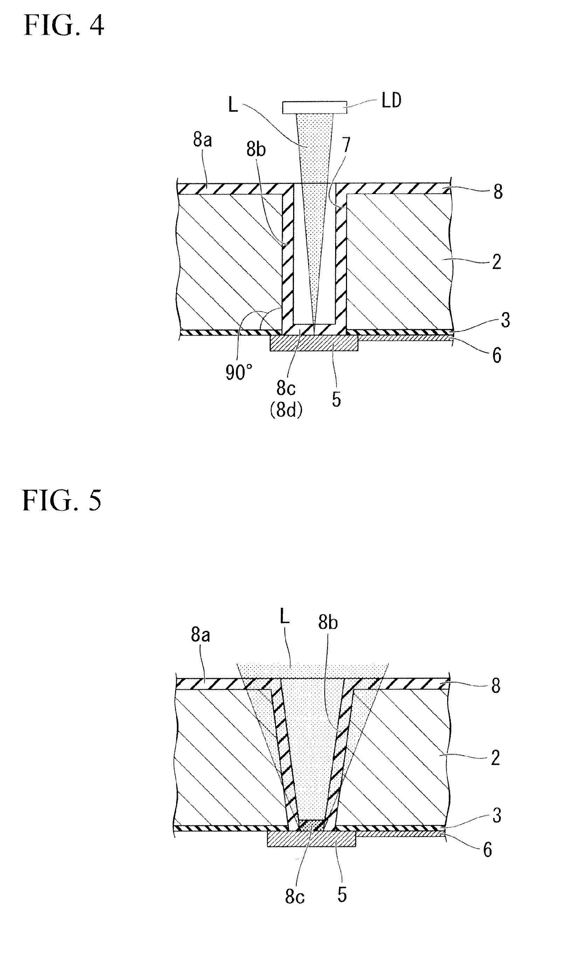

The laser beam L is focused using a light focusing portion, such as an objective lens, a reflective lens, a spherical lens and an aspherical lens, and irradiated while scanning with the beam using the light focusing portion. During this process, as shown in FIG. 5, the laser beam L may be irradiated by forming a one-dimensional irradiation region using a cylindrical lens or the like (not shown). In this manner, the processing time can be shortened.
Moreover, the laser beam L may be focused and irradiated two-dimensionally by defocusing the light focusing portion or employing a holographic technique or the like. As a result, the modified region 8d can be collectively formed even without the scanning using the laser beam L.

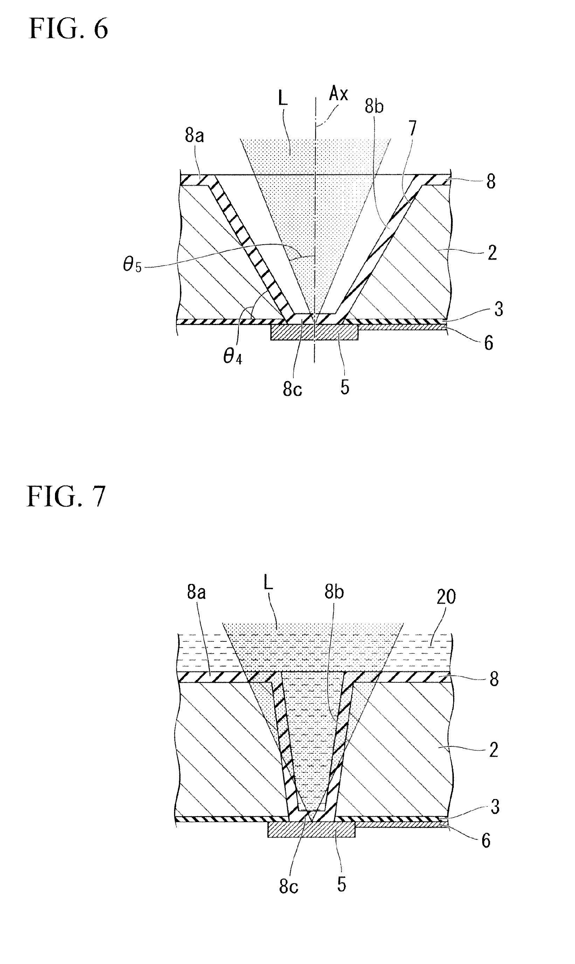

In addition, as shown in FIG. 6, the laser beam L will not be irradiated onto the inner peripheral surface of the through holes 7 in the semiconductor substrate 2 when the angle of the inner peripheral surface is larger than the numerical aperture for focusing the laser beam L in those cases where the through holes 7 are seen in the cross sections that include these axes (that is, in those cases where seen in such cross sections, when an angle θ₄ formed between the surface of the semiconductor substrate 2 where the insulating layer 3 is formed and the inner peripheral surface of the through holes 7 is smaller than the maximum angle θ₅ of the laser beam L incident on the through holes 7 with respect to the optical axis Ax), or when the angle θ₄ of the inner peripheral surface of the through holes 7 can be regarded as equivalent to or at about the same level as the numerical aperture for focusing the laser beam L (i.e., θ4 ≈ θ₅). For this reason, there is no need to limit the wavelength of the laser beam L to a region at which the beam transmits silicon. In this case, even when the laser beam having a wavelength within a visible region or an ultraviolet region is used, the laser beam can be irradiated for the processing in the same manner.

Irradiation of the laser beam L is carried out, for example, by providing a shutter (not shown) in the optical path of the laser beam L and opening this shutter only when the light focusing portion of the laser beam L reached onto the through holes 7 while scanning with the laser beam L. Alternatively, by using a laser beam L having an energy intensity which is a pulse intensity causing no structural change inside silicon and is less than or equal to the energy intensity where the ablation of the insulating layer 8, the interconnection section 6 and the semiconductor substrate 2 can be suppressed, the modified regions 8d can be formed only in the insulating layer 8c at the bottom of the through holes 7 without providing the aforementioned shutter in the optical path.

### (Modified region removal step)

Subsequently, as shown in FIG. 3B, each of the modified regions 8d is removed by dry etching. In this dry etching, each of the modified regions 8d is dry etched extremely fast (i.e., at a rate several tens of times higher) compared to the non-modified regions (portions corresponding to the insulating layers 8a and 8b). For this reason, only each of the insulating layers 8c at the bottom face of the through holes 7 can be easily removed selectively.

Here, the insulating layers 8a and 8b formed on the surface of the semiconductor substrate 2 and the inner peripheral surface of the through holes 7, respectively, are also being dry etched as in the prior art. However, since the dry etching process proceeds overwhelmingly faster in the insulating layer 8c (modified regions 8d) in which structural changes (reforming) have occurred, the insulating layers 8a and 8b are hardly affected by dry etching and are not removed. For this reason, the insulation properties are retained in a portion where these insulating layers 8a and 8b have been formed, so as to enable the formation of a contact portion in the through hole 10. Accordingly, conditions for the thickness of the insulating layers 8a, 8b and 8c can be easily set. As a result, the degree of design freedom for the shape of the through holes 7 is enhanced, and the processing throughput is expected to improve, and thus the insulating layer 8c (modified region 8d) can be etched effectively even with the through holes 7 having a high aspect ratio.

Examples of the dry etching process include the RIE mode etching, which is an anisotropic etching process, such as the ion etching and etching using radicals.
The etching rate in dry etching is largely dependent on the irradiation conditions of the laser beam. For this reason, by also irradiating a pulse laser beam having a pulse duration on the order of not more than 10 picoseconds onto the insulating layers 8a and 8b in the same manner, it is possible to control the etching rate for the insulating layers 8a, 8b and 8c and to control the thickness of the insulating layers 8a, 8b and 8c.

Note that the etching process is not limited to a dry etching process. The modified regions 8d can also be removed through a wet etching process by using any of the etchants capable of etching the modified regions 8d, which have undergone a structural change, by the irradiation of the laser beam. For example, a wet etching process using a solution based on hydrofluoric acid (HF) can be employed.
In addition, as shown in FIG. 7, the insulating layer 8c can also be removed by the so-called laser assisted etching process, in which a portion irradiated with the laser beam L is selectively removed by irradiating the laser beam L while immersing the through holes 7 in a chemical solution 20. In this process, as the chemical solution 20, a solution based on hydrofluoric acid (HF) can be used in the same manner.

### (Conductive layer formation step)

Subsequently, as shown in FIG. 3C, the conductive layer 9 is formed on the insulating layer 8 formed inside the through holes 7 and on the electrode pads 5 exposed inside the through holes 7, so as to be electrically connected with the electrode pads 5.
The formation of the conductive layer 9 can be carried out by a sputtering method, a CVD method, a plating method, the filling of the molten metal, the filling of the metal paste or the like. In this manner, the semiconductor device 1 having the through electrode 10 is prepared.

As described above, according to the method for manufacturing a semiconductor device of the present embodiment, since a portion of the insulating layer 8 (i.e., the insulating layer 8c) which covers the bottom face of the through holes 7 is reformed and then removed, only the insulating layer 8c which is a portion covering the electrode pads 5 can be removed selectively, while leaving the insulating layer 8a formed in the periphery of the opening of the through holes 7 and the insulating layer 8b formed in the inner peripheral surface of the through holes 7. In this manner, conditions for the thickness of the insulating layers 8a, 8b and 8c, which are formed in the periphery of the opening, the inner peripheral surface and the bottom face of the through holes 7, respectively, can be easily set.

The method for manufacturing a semiconductor device of the present embodiment can be applied even when the inner peripheral surface of the through holes 7 is formed so as to form an angle of about 90° (substantially perpendicular) with respect to the surface of the semiconductor substrate 2 as shown in FIG. 4.
Also in this case, the laser beam L is first irradiated only to the insulating layer 8c which is covering the electrode pads 5 inside the through holes 7 in the same manner, thereby forming the modified regions 8. Thereafter, the modified regions 8d will be removed by dry etching.
In the case of the through holes 7 formed perpendicularly with respect to the semiconductor substrate 2, it has conventionally been necessary to selectively etch only the insulating layer 8c by an anisotropic etching process or the like when removing the insulating layer 8c arranged on the electrode pads 5. During this process, there has been a problem in that the insulating layers 8a and 8b are also being etched at the same time. On the other hand, according to the method for manufacturing a semiconductor device of the present embodiment, only the insulating layer 8c on the electrode pads 5 can be easily reformed and removed.

In addition, when carrying out the conductor formation inside the through holes 7 using a sputtering method, a plating method or the like, in general, the processing becomes easier as the slope of the inner peripheral surface of the through holes 7 increases (i.e., as the angle θ₂ shown in FIG. 15 reduces). However, with regard to the insulating layer 101b formed in the inner peripheral surface of the through holes 106, it becomes more prone to be etched as the slope of the inner peripheral surface of the through holes 106 increases. For this reason, it has been difficult to form a through electrode with such a shape. However, by using the method for manufacturing a semiconductor device of the present embodiment, it becomes easy to form the above-mentioned shape.
Further, since the time for forming and etching the insulating layers is shortened, the throughput during the processing is expected to improve. As a result, according to the method for manufacturing a semiconductor device of the present embodiment, it becomes possible to form a through electrode which is easily obtained and also with an improved degree of design freedom with respect to the shape thereof.

Note that the present invention is not limited only to the removal of the insulating layer 8c and can also be applied when selectively etching the bottom face of the through holes with a similar structure and having a high aspect ratio. The present invention can be applied for etching a material, which causes a structural change when irradiated with a laser beam having a pulse width of not more than 10 picoseconds and also which can be subjected to dry etching, wet etching or laser assisted etching, such as quartz and borosilicate glass.

### [Second Embodiment]

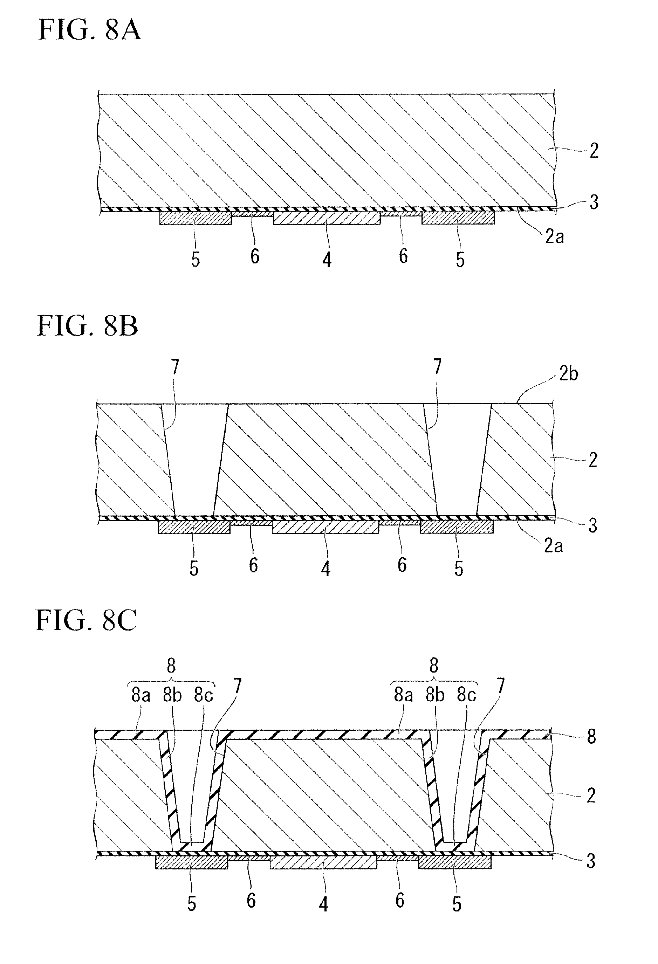

A second embodiment of the method for manufacturing a semiconductor device of the present invention will be described below using FIGS. 8A to 9C. It should be noted that the constitution of the semiconductor device manufactured by the method for manufacturing a semiconductor device of the present embodiment is substantially the same as the constitution of the semiconductor device 1 of the above-mentioned first embodiment which has been described using FIG. 1. Accordingly in the following description, the same components as those which have been explained in the above-mentioned first embodiment will be provided with the same reference symbol and the duplicate descriptions thereof will be omitted. Each step in the present embodiment will be described below in order.

### (Electrode formation step)

First, the electrode pad 5 is formed on one surface of the semiconductor substrate 2. That is, as shown in FIG. 8A, the semiconductor substrate 2 in which the functional element 4 is formed via the insulating layer 3 is prepared, and a plurality of electrode pads 5 (I/O pads) and a plurality of interconnection sections 6 are formed on top of the insulating layer 3 which constitutes the one surface 2a (a lower surface present in the lower side of the same drawing).

### (Through hole formation step)

Subsequently, as shown in FIG. 8B, a plurality of through holes 7 are formed from the other surface 2b of the semiconductor substrate 2. Note that in the above-mentioned first embodiment, although each of the through holes 7 is formed so as to expose the electrode pads 5, in the present embodiment, formation of the through holes 7 is halted while leaving the insulating layer 3 to remain. In other words, the formation is halted at a state so that the electrode pads 5 are not exposed, although the insulating layer 3 is exposed, at the bottom of each of the through holes 7.

### (Insulating layer formation step)

Subsequently, the insulating layer 8 is formed at least on the inner peripheral surface and the periphery of the opening of each of the through holes 7, and on the insulating layer 3 exposed inside each of the through holes 7. That is, as shown in FIG. 8C, the insulating layer 8 is formed at least on the inner wall surface (i.e., the inner peripheral surface and the bottom face) and the periphery of the opening of the through holes 7.

### (Modifying step)

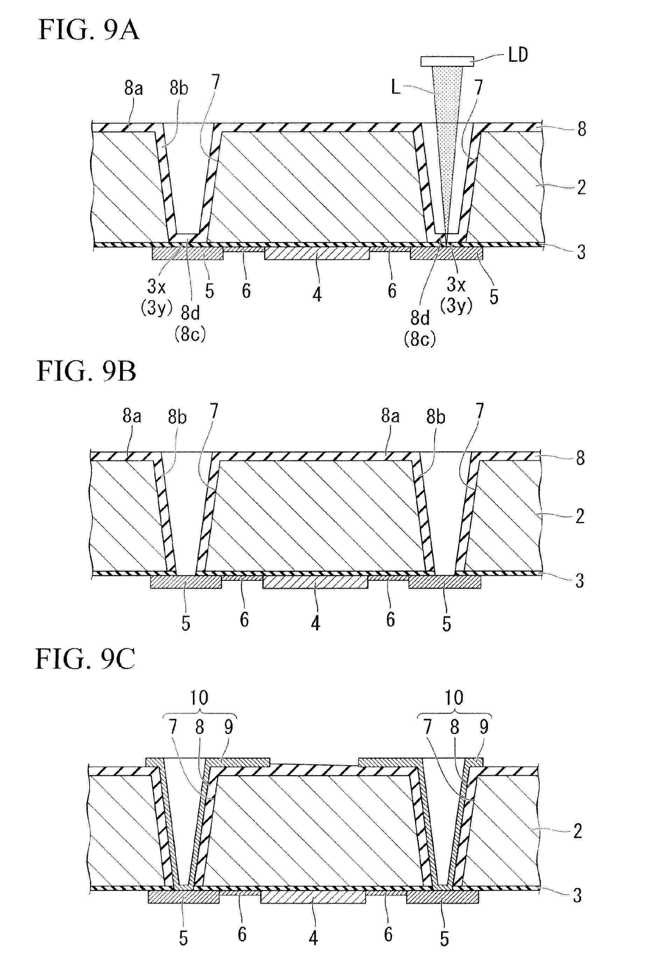

Subsequently, as shown in FIG. 9A, a laser beam L having a pulse duration on the order of not more than 10 picoseconds is irradiated from a laser device LD and focused only at the insulating layer 8c, which covers the bottom faces of the through holes 7 (i.e., the electrode pads 5), and a portion 3x of the insulating layer 3 which is present immediately below the insulating layer 8c, thereby collectively reforming the insulating layer 8c and the portion 3x. As the laser beam L used for reforming, a laser beam having a wavelength range which transmits silicon (semiconductor substrate 2) is used. By scanning the bottom face of the through hole 7 with the light focusing portion, an insulating layer (i.e., the modified region 8d and the modified region 3y) with a changed structure is formed at the bottom face. As a result, a structural change (reforming) can be easily caused at the insulating layer 8c and the portion 3x where the laser beam L has been irradiated.

As the laser beam L used for reforming, it is preferable to use a laser beam having a pulse energy lower than the energy at which the ablation or transpiration of the insulating layer 8 and the insulating layer 3 occurs.
It is also possible to cause the ablation and removal of the insulating layer 8c and the portion 3x by irradiating a laser beam having a pulse duration on the order of not more than 10 picoseconds, a laser beam having a longer pulse duration than the above laser beam, a CW laser beam or the like onto the insulating layer 8c and the portion 3x. However, in such a case, damage to the electrode pads 5 will be great. As a result, problems arise, such as the deformation, breakage, partial loss or the like of the electrode pads 5, and the attachment of residues inside the through holes 7. By using a laser beam having a pulse energy lower than the energy, at which the ablation or transpiration of the insulating layer 8 and the portion 3x occurs, as the laser beam L, the insulating layer 8c and the portion 3x can be reformed by causing only a purely structural change to the insulating layer 8c and the portion 3x without damaging the electrode pads 5.
As described above, by irradiating a pulse laser beam L having a pulse duration on the order of not more than 10 picoseconds while suppressing the energy to a level equal to or less than the energy at which the ablation or transpiration of the insulating layer 8 and the insulating layer 3 occurs, the processing without causing damage or the like to the electrode pads 5 can be carried out.

### (Modified region removal step)

Subsequently, as shown in FIG. 9B, each of the modified regions 8d is removed together with the respective modified regions 3y by dry etching. In this dry etching, each of the modified regions 8d and the respective modified regions 3y are dry etched extremely fast (i.e., at a rate several tens of times higher) compared to the non-modified regions (portions corresponding to the insulating layers 8a and 8b). For this reason, only each of the insulating layers 8c at the bottom face of the through holes 7 and the respective modified regions 3y can be easily removed selectively.

Here, the insulating layers 8a and 8b formed on the surface of the semiconductor substrate 2 and the inner peripheral surface of the through holes 7, respectively, are also being dry etched as in the prior art. However, since the dry etching process proceeds overwhelmingly faster in the modified regions 8d and the respective modified regions 3y in which structural changes (reforming) have occurred, the insulating layers 8a and 8b are hardly affected by dry etching and are not removed. For this reason, the insulation properties are retained in a portion where these insulating layers 8a and 8b have been formed, so as to enable the formation of a contact portion in the through hole 10. Accordingly, conditions for the thickness of the insulating layers 8a, 8b and 8c can be easily set. As a result, the degree of design freedom for the shape of the through holes 7 is enhanced, and the processing throughput is expected to improve, and thus the modified regions 8d and the respective modified regions 3y can be collectively etched effectively even with the through holes 7 having a high aspect ratio.

Examples of the dry etching process include the RIE mode etching, which is an anisotropic etching process, such as the ion etching and etching using radicals.
The etching rate by dry etching is largely dependent on the irradiation conditions of the laser beam. For this reason, by also irradiating a pulse laser beam having a pulse duration on the order of not more than 10 picoseconds onto the insulating layers 8a and 8b in the same manner, it is possible to control the etching rate for the insulating layers 8a, 8b and 8c and to control the thickness of the insulating layers 8a, 8b and 8c.

Note that the etching process is not limited to a dry etching process. The modified regions 8d and the respective modified regions 3y can also be removed through a wet etching process by using any of the etchants capable of etching the modified regions 8d and the respective modified regions 3y, which have undergone a structural change, by the irradiation of the laser beam. For example, a wet etching process using a solution based on hydrofluoric acid (HF) can be employed.

### (Conductive layer formation step)

Subsequently, as shown in FIG. 9C, the conductive layer 9 is formed on the insulating layer 8 formed inside the through holes 7 and on the electrode pads 5 exposed inside the through holes 7, so as to be electrically connected with the electrode pads 5.
The formation of the conductive layer 9 can be carried out by a sputtering method, a CVD method, a plating method, the filling of the molten metal, the filling of the metal paste or the like. In this manner, the semiconductor device 1 having the through electrode 10 is prepared.

As described above, according to the method for manufacturing a semiconductor device of the present embodiment, since a portion of the insulating layer 8 (i.e., the insulating layer 8c) which covers the bottom face of the through holes 7 and the portion 3x are reformed and then removed, only the insulating layer 8c, which is a portion covering the electrode pads 5, and the portion 3x can be removed selectively, while leaving the insulating layer 8a formed in the periphery of the opening of the through holes 7 and the insulating layer 8b formed in the inner peripheral surface of the through holes 7. In this manner, conditions for the thickness of the insulating layers 8a, 8b and 8c, which are formed in the periphery of the opening, the inner peripheral surface and the bottom face of the through holes 7, respectively, can be easily set.
Moreover, since a portion of the insulating layer 8 (i.e., the insulating layer 8c) which covers the bottom face of the through holes 7 and the portion 3x of the insulating layer 3 which covers the electrode pads 5 are reformed collectively, the step for removing the portion 3x can be omitted in the through hole formation step. Furthermore, contamination associated with the opening formation can be suppressed.

### [Third Embodiment]

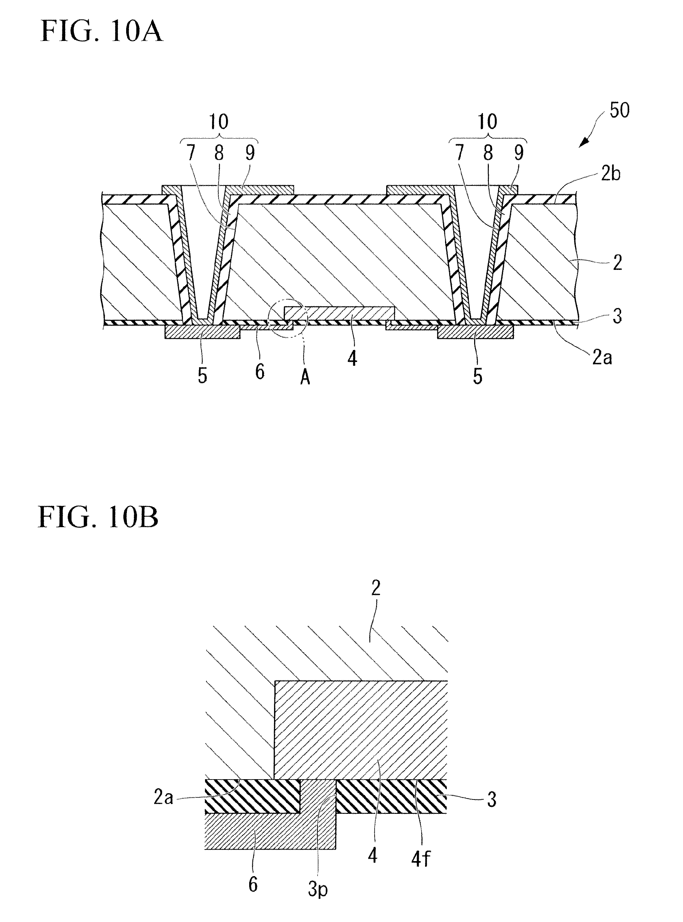

A third embodiment of the method for manufacturing a semiconductor device of the present invention will be described below using FIGS. 10A to 12C. Since the constitution of the semiconductor device manufactured by the method for manufacturing a semiconductor device of the present embodiment is partially different from the constitution of the semiconductor device 1 of the above-mentioned first embodiment which has been described using FIG. 1, the differences will be mainly described. Note that the same components as those in the above-mentioned first embodiment will be provided with the same reference symbol and the duplicate descriptions thereof will be omitted.

As shown in FIGS. 10A and 10B, a semiconductor device 50 of the present embodiment is particularly different in that the functional element 4 is formed so as to be embedded in one surface (the surface in the lower side of the same drawings) of the semiconductor substrate 2 in advance, and that the interconnection section 6 is electrically connecting between the functional element 4 and each of the electrode pads 5 via a pore 3p formed in the insulating layer 3.
That is, as shown in FIG. 10A, in the present embodiment, the functional element 4 is formed while being embedded within one surface 2a of the semiconductor substrate 2. The functional element 4 is arranged so that the position of its lower surface 4f corresponds with that of the one surface 2a, and the lower surface 4f is covered by the insulating layer 3.

In addition, as shown in FIG. 10B, a plurality of pores 3p are formed on top of the insulating layer 3 at positions corresponding to the functional element 4. Further, the interconnection section 6 having one end electrically connected with the electrode pad 5 is electrically connected through the other end to the lower surface 4f of the functional element 4 via the pore 3p.
Each steps in a method for manufacturing the semiconductor device 50 of the present embodiment having the constitution as explained above will be described below in order.

### (Electrode formation step)

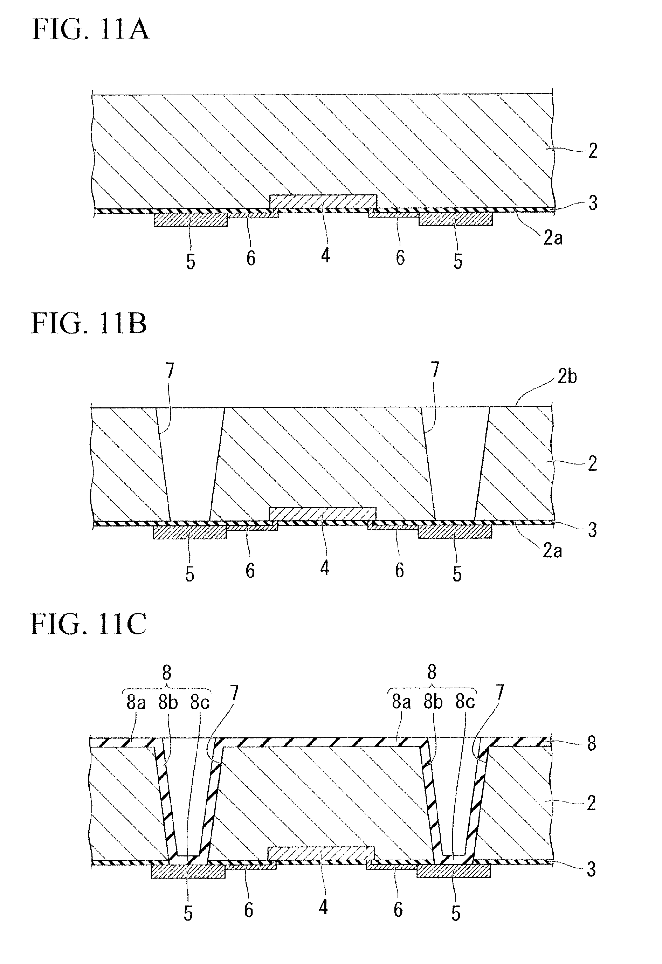

First, the electrode pad 5 is formed on one surface 2a of the semiconductor substrate 2 where the functional element 4 has been formed in advance. That is, as shown in FIG. 11A, the semiconductor substrate 2 in which the functional element 4 is formed via the insulating layer 3 is prepared, and a plurality of electrode pads 5 (I/O pads) and a plurality of interconnection sections 6 are formed on top of the insulating layer 3 which constitutes the one surface 2a (a lower surface present in the lower side of the same drawing) of the semiconductor substrate 2.
Note that the insulating layer 3 is formed in advance prior to the electrode formation step due to the step for forming on the one surface 2a (i.e., the second insulating layer formation step).

### (Through hole formation step)

Subsequently, as shown in FIG. 11B, a plurality of through holes 7 are formed so that at least a portion of the electrode pads 5 is exposed from the other surface 2b of the semiconductor substrate 2.
These through holes 7 are formed so that the electrode pads 5 are exposed from the upper surface side of the semiconductor substrate 2.

### (Insulating layer formation step)

Subsequently, the insulating layer 8 is formed at least on the inner peripheral surface and the periphery of the opening of each of the through holes 7, and on each of the electrode pads 5 exposed inside each of the through holes 7. That is, as shown in FIG. 11C, the insulating layer 8 is formed at least on the inner wall surface (i.e., the inner peripheral surface and the bottom face) and the periphery of the opening of the through holes 7. The insulating layer 8 can be formed, for example, by depositing silicon oxide (SiO₂) by a plasma CVD method or the like.

### (Modifying step)

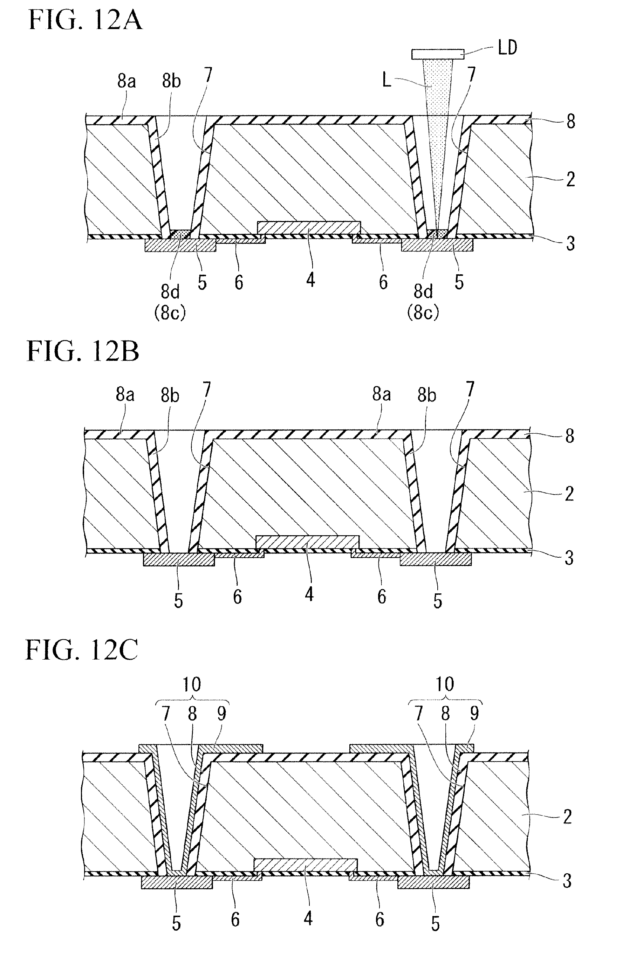

Subsequently, a portion of the insulating layer 8 which covers each of the electrode pads 5 exposed inside each of the through holes 7 is reformed, thereby forming a modified region. That is, as shown in FIG. 12A, a laser beam L having a pulse duration on the order of not more than 10 picoseconds is irradiated from a laser device LD and focused only at the insulating layer 8c which covers the bottom faces of the through holes 7 (i.e., the electrode pads 5), thereby reforming the insulating layer 8c. As the laser beam L used for reforming, a laser beam having a wavelength range which transmits silicon (semiconductor substrate 2) is used. By scanning the bottom face of the through hole 7 with the beam using the light focusing portion, an insulating layer (i.e., the modified region 8d) with a changed structure is formed at the bottom face. As a result, a structural change (reforming) can be easily caused at a portion of the insulating layer 8c where the laser beam L has been irradiated.

### (Modified region removal step)

Subsequently, as shown in FIG. 12B, each of the modified regions 8d is removed by dry etching. In this dry etching, each of the modified regions 8d is dry etched extremely fast (i.e., at a rate several tens of times higher) compared to the non-modified regions (portions corresponding to the insulating layers 8a and 8b). For this reason, only each of the insulating layers 8c at the bottom face of the through holes 7 can be easily removed selectively.

### (Conductive layer formation step)

Subsequently, as shown in FIG. 12C, the conductive layer 9 is formed on the insulating layer 8 formed inside the through holes 7 and on the electrode pads 5 exposed inside the through holes 7, so as to be electrically connected with the electrode pads 5.
The formation of the conductive layer 9 can be carried out by a sputtering method, a CVD method, a plating method, the filling of the molten metal, the filling of the metal paste or the like. In this manner, the semiconductor device 50 having the through electrode 10 is prepared.

As described above, according to the method for manufacturing a semiconductor device of the present embodiment, since a portion of the insulating layer 8 (i.e., the insulating layer 8c) which covers the bottom face of the through holes 7 is reformed and then removed, only the insulating layer 8c which is a portion covering the electrode pads 5 can be removed selectively, while leaving the insulating layer 8a formed in the periphery of the opening of the through holes 7 and the insulating layer 8b formed in the inner peripheral surface of the through holes 7. In this manner, conditions for the thickness of the insulating layers 8a, 8b and 8c, which are formed in the periphery of the opening, the inner peripheral surface and the bottom face of the through holes 7, respectively, can be easily set.

Although each of the embodiments of the method for manufacturing a semiconductor device according to the present invention has been described above, the present invention is not limited only to these embodiments, and appropriate modifications may be made thereto if necessary.

### INDUSTRIAL APPLICABILITY

The present invention can be applied widely to a method for producing a semiconductor device equipped with a through electrode.

### DESCRIPTION OF THE REFERENCE SYMBOLS

1,50: Semiconductor device
2: Semiconductor substrate
2a: One surface
5: Electrode pad (electrode)
2b: The other surface
7: Through hole
8: Insulating layer (first insulating layer)
8c: First portion
8d, 3y: Modified region
9: Conductive layer
3: Insulating layer (second insulating layer)
L: Laser beam

## Claims

1. A method for manufacturing a semiconductor device comprising:
an electrode formation step of forming an electrode on one surface of a semiconductor substrate;
a through hole formation step of forming a through hole in the thickness direction of the semiconductor substrate starting from a position on the other surface of the semiconductor substrate corresponding to the position of the electrode formed on the one surface of the substrate;
a first insulating layer formation step of forming a first insulating layer on at least an inner circumferential surface, a periphery of an opening, and a bottom surface of the through hole;
a modifying step of reforming a first portion of the first insulating layer formed on the bottom surface of the through hole to form a modified region;
a modified region removal step of removing the modified region to expose the electrode inside the through hole; and
a conductive layer formation step of forming a conductive layer on the electrode exposed inside the through hole and on the first insulating layer such that the conductive layer is electrically connected with the electrode.

2. The method for manufacturing a semiconductor device according to Claim 1, further comprising a second insulating layer formation step of forming a second insulating layer on the one surface prior to the electrode formation step,
wherein the second insulating layer is removed at the same time as the formation of the through hole in the through hole formation step.

3. The method for manufacturing a semiconductor device according to Claim 1, further comprising a second insulating layer formation step of forming a second insulating layer on the one surface prior to the electrode formation step,
wherein a second portion of the second insulating layer which corresponds to the first portion is collectively reformed together with the first portion, thereby forming the modified region in the modifying step.

4. The method for manufacturing a semiconductor device according to Claim 1,
wherein the modifying step is carried out by focusing and irradiating a laser beam having a pulse duration of not more than 10 picoseconds on the first portion.

5. The method for manufacturing a semiconductor device according to Claim 4,
wherein, the laser beam has a pulse energy lower than the energy, at which the ablation or transpiration of the first insulating layer occurs.
